# EUROPEAN PATENT APPLICATION

(11) **EP 4 807 379 A1**
(43) Date of publication of application: **16.09.2026**
(21) Application number: 24889049.3
(22) Date of filing: 04.11.2024
(51) Int. Cl.: G01R 31/389, G01R 31/385, G01R 19/30, G01R 31/382, G01R 19/10

(54) **BATTERY DIAGNOSIS DEVICE AND BATTERY DIAGNOSIS METHOD USING SAME**

(30) Priority: 09.11.2023 KR 20230154179
(71) Applicant: Mintech Co., Ltd., Daejeon 34026 (KR)
(72) Inventor: CHOI, Sung Ho, Daejeon 34008 (KR); JEONG, Ji Hyeon, Daejeon 34008 (KR); HONG, Young Jin, Daejeon 34010 (KR); LEE, Young Jae, Daejeon 34010 (KR); CHO, Seokchun, Daejeon 36044 (KR); GU, Gwanmo, Daejeon 34020 (KR); HWANG, Dongchul, Daejeon 34002 (KR); KIM, Sungwook, Pohang-si, Gyeongsangbuk-do 37538 (KR)
(74) Representative: Schön, Christoph
(86) International application number: PCT/KR2024/017111
(87) International publication number: WO 2025/100861

(57) **Abstract**

A battery diagnostic apparatus capable of easily calculating a state of power of a battery and a battery diagnostic method using the same are disclosed.

According to one aspect of the present invention, the battery diagnostic apparatus comprises an AC impedance measurement unit configured to measure an AC impedance value of a battery based on a lowest voltage value within an available voltage range of the battery and a current discharge voltage value of the battery, and an SOP calculation unit configured to calculate a current state of power (SOP) of the battery based on the measured AC impedance value.

## Description

### TECHNICAL FIELD

The present invention relates to a battery diagnostic apparatus and a battery diagnostic method using the same, and more particularly, to a battery diagnostic apparatus capable of easily calculating a state of power (SOP or Power life) of a battery by using Electrochemical Impedance Spectroscopy (EIS), and a battery diagnostic method using the same.

### BACKGROUND ART

Batteries having electrical characteristics such as high applicability according to product groups and high energy density are also referred to as storage batteries or secondary batteries, and are attracting attention as a new energy source for improving environmental friendliness and energy efficiency in that not only do they have the primary advantage of reducing the use of fossil fuels, but also no by-products are generated according to the use of energy.

Accordingly, batteries are commonly applied to portable devices as well as electric vehicles (EVs) driven by an electrical driving source or Energy Storage Systems (ESSs), and research and development on a Battery Management System (BMS), a battery balancing circuit, a switching circuit, and the like are being actively conducted for more efficient battery management.

In particular, the BMS can manage a State Of Charging (SOC), a State Of Health (SOH), a maximum allowable input/output power amount, an output voltage, and the like of a battery by using state information of the battery, and among these, a technology for estimating a replacement time by predicting the lifespan of the battery has become a core technology for more stable system operation.

Meanwhile, as various devices using batteries, such as electric vehicles, have recently increased rapidly, research on a technology for accurately calculating a state of power (SOP) of a battery through a Battery Management System (BMS) is increasing.

The state of power of such a battery may be an indicator for determining whether power required for operation of an electric vehicle can be supplied without a problem in a starting battery.

However, no method for easily and conveniently calculating the state of power of such a battery has been conventionally known or studied.

### DISCLOSURE OF THE INVENTION

### TECHNICAL PROBLEM

The present invention has been made to solve the above-described problems, and an object thereof is to provide a battery diagnostic apparatus capable of easily calculating a state of power of a battery, and a battery diagnostic method using the same.

However, the technical problem to be solved by the present invention is not limited to the above-described problem, and another problem not mentioned may be clearly understood by those skilled in the art from the description of the invention set forth below.

### TECHNICAL SOLUTION

According to one aspect of the present invention, a battery diagnostic apparatus includes: an AC impedance measurement unit configured to measure an AC impedance value of a battery based on a lowest voltage value within an available voltage range of the battery and a current discharge voltage value of the battery; and an SOP calculation unit configured to calculate a current state of power (SOP) of the battery based on the measured AC impedance value.

Preferably, the AC impedance value of the battery may include a first resistance value, which is an internal resistance value of the battery calculated by the AC impedance measurement unit when the battery is in an initial state and a state of charge (SOC) is in a range of 10% to 90% at a temperature of 25°C.

Preferably, the AC impedance measurement unit may be configured to calculate the first resistance value when the SOC of the battery is 50%.

Preferably, the AC impedance value of the battery may further include a second resistance value, which is an internal resistance value of the battery when the SOP of the battery is 0%, calculated by the AC impedance measurement unit based on a lowest voltage value within an available voltage range of the battery.

Preferably, the second resistance value may be calculated as a ratio of a current value when the battery is at the lowest voltage value to a difference between an open circuit voltage (OCV) value of the battery when the SOC is in a range of 10% to 90% at a temperature of 25°C and the lowest voltage value within the available voltage range of the battery

Preferably, the AC impedance measurement unit may be configured to calculate the second resistance value when the SOC of the battery is 50%.

Preferably, the AC impedance value of the battery may further include a third resistance value, which is a current internal resistance value of the battery calculated by the AC impedance measurement unit based on a current discharge voltage value of the battery.

Preferably, the third resistance value may be calculated as a ratio of a current value of the battery to a difference between an open circuit voltage (OCV) value of the battery when the SOC is in a range of 10% to 90% at a temperature of 25°C and a current discharge voltage value of the battery.

Preferably, the AC impedance measurement unit may be configured to calculate the third resistance value when the SOC of the battery is 50%.

Preferably, the SOP calculation unit may be configured to calculate a current state of power of the battery based on a ratio of a second value, which is a difference between the second resistance value and the first resistance value, to a first value, which is a difference between the third resistance value and the first resistance value.

According to one aspect of the present invention, a battery diagnostic method includes: measuring an AC impedance value of a battery based on a lowest voltage value within an available voltage range of the battery and a current discharge voltage value of the battery; and calculating a current state of power of the battery based on the measured AC impedance value.

### ADVANTAGEOUS EFFECTS

According to the present invention, since a state of power of a battery can be calculated by using an AC impedance value of the battery in an initial state when the SOP is 100% and an AC impedance value of the battery when the SOP is 0%, there is an advantage in that the SOP, which is an indicator for determining performance of the battery, can be calculated more easily and conveniently without a separate complicated calculation apparatus or calculation method.

In addition, various other additional effects may be achieved by various embodiments of the present invention. With respect to the various effects of the present invention, the effects will be described in detail in each embodiment, or a description thereof will be omitted for effects that can be easily understood by those skilled in the art.

### BRIEF DESCRIPTION OF THE DRAWINGS

The following drawings attached to the present specification illustrate preferred embodiments of the present invention and serve to further facilitate understanding of the technical spirit of the present invention together with the detailed description of the invention to be described below, and therefore, the present invention should not be construed as being limited only to matters set forth in such drawings.
FIG. 1 is a view illustrating a battery diagnostic apparatus according to an embodiment of the present invention.
FIG. 2 is a flowchart illustrating a battery diagnostic method according to an embodiment of the present invention.

### MODE FOR CARRYING OUT THE INVENTION

The advantages and features of the present invention, and methods for achieving the same, will become apparent with reference to embodiments described in detail below in conjunction with the accompanying drawings. However, the present invention is not limited to the embodiments disclosed below and may be implemented in various different forms, and the present embodiments are provided only to make the disclosure of the present invention complete and to fully inform those skilled in the art to which the present invention pertains of the scope of the present invention, and the present invention is defined only by the scope of the claims.

The terminology used herein is for the purpose of describing embodiments and is not intended to limit the present invention. As used herein, the singular form includes the plural form as well, unless the context clearly indicates otherwise. As used herein, the terms "comprises" and/or "comprising" do not exclude the presence or addition of one or more other components in addition to the stated components.

Throughout the specification, like reference numerals refer to like components, and "and/or" includes each of the mentioned components and all combinations of one or more thereof. Although terms such as "first" and "second" are used to describe various components, it is to be understood that these components are not limited by these terms. These terms are used only for the purpose of distinguishing one component from another component. Accordingly, a first component referred to below may also be a second component within the technical spirit of the present invention.

Unless otherwise defined, all terms (including technical and scientific terms) used herein may be used with meanings commonly understood by those skilled in the art to which the present invention pertains. In addition, terms defined in generally used dictionaries are not to be interpreted ideally or excessively unless they are clearly and specifically defined otherwise.

Accordingly, the embodiments described in the present specification and the configurations illustrated in the drawings are merely one most preferred embodiment of the present invention and do not represent all of the technical spirit of the present invention, and thus it should be understood that various equivalents and modifications capable of substituting therefor may exist at the time of filing of the present application.

In describing the present invention, a "battery" may be a storage battery or a secondary battery that stores power through charging. Further, the battery may include at least one of a battery pack composed of a plurality of battery modules, at least one battery module within the battery pack, a battery module composed of a plurality of battery cells, at least one battery cell within the battery module, a representative module representing the plurality of battery modules, and a representative cell representing the plurality of battery cells.

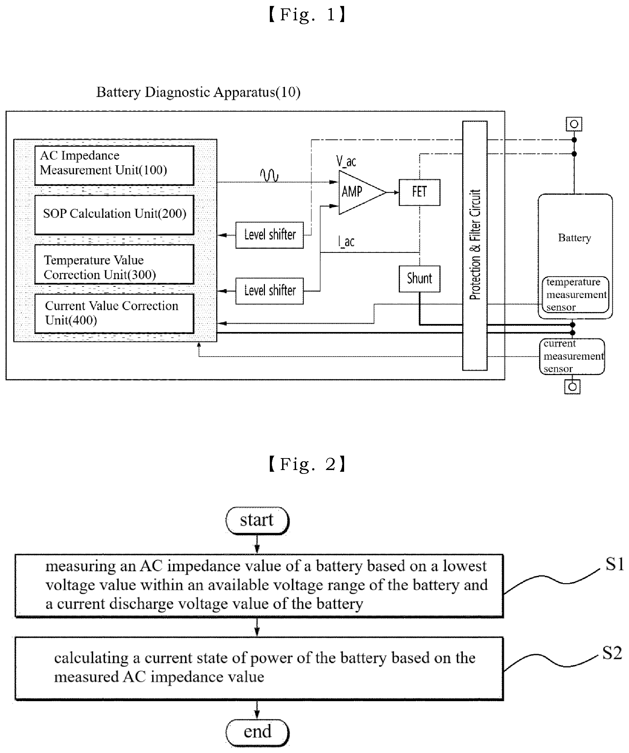

FIG. 1 is a view illustrating a battery diagnostic apparatus (10) according to an embodiment of the present invention.

Referring to FIG. 1, a battery diagnostic apparatus (10) according to an embodiment of the present invention may include an AC impedance measurement unit (100) and an SOP calculation unit (200).

In one embodiment, the AC impedance measurement unit (100) may use Electrochemical Impedance Spectroscopy (EIS).

As an example, the AC impedance measurement unit (100) and the SOP calculation unit (200) may be provided in a Microcontroller Unit (MCU).

At this time, the AC impedance measurement unit (100) may generate a sinusoidal wave (e.g., a sine wave or a cosine wave) having a specific magnitude and frequency, as illustrated in FIG. 1. Further, the generated sinusoidal wave may be amplified by an AMP to generate a discharge current through an FET (Field Effect Transistor), and thus may be configured to measure an AC impedance value of the battery through the AC impedance measurement unit (100). At this time, the level shifter illustrated in FIG. 1 may be a configuration for shifting a voltage of a signal of the sinusoidal wave generated by the AC impedance measurement unit (100) to a voltage range that is easy to measure in consideration of precision and resolution.

In addition, the SOP calculation unit (200) may include a processor, and the processor may be implemented as an array of logic gates, a microprocessor, a Central Processing Unit (CPU), a Graphics Processing Unit (GPU), an Application Processor (AP), or a combination thereof.

Specifically, the AC impedance measurement unit (100) may be configured to measure an AC impedance value of a battery based on a lowest voltage value within an available voltage range of the battery and a current discharge voltage value of the battery.

The SOP calculation unit (200) may be configured to calculate a current state of power (SOP) of the battery based on the measured AC impedance value. At this time, the SOP of the battery refers to a value obtained by expressing, as a percentage (%), an output performance of a current state of the battery relative to an initial output performance of the battery.

Here, the battery to be diagnosed by the battery diagnostic apparatus (10) may be a starting battery capable of providing power required for vehicle operation in the form of instantaneous high output. A performance determination indicator of such a starting battery may include the above-described SOP of the battery.

Specifically, the AC impedance value of the battery may include a first resistance value.

The first resistance value may be expressed as Equation 1 below. ${R}_{100} = Fresh @ SOCx$

In Equation 1, R100 is the first resistance value, Fresh indicates that the battery is in an initial state in which the battery is not aged, and SOCx indicates that the first resistance value is calculated in a state in which a state of charge (SOC) of the battery is an arbitrary SOC X%.

That is, the first resistance value may refer to an internal resistance value of the battery calculated by the AC impedance measurement unit (100) when the battery is in an initial state, at 25°C, and within an arbitrary state of charge (SOC) range. Further, the first resistance value may refer to an internal resistance value of the battery when the SOP is 100%.

Meanwhile, in the present invention, the SOC represents an available capacity of the battery, that is, a remaining capacity, as a percentage, wherein the SOC is 100% when the battery is in a maximum charged state, and the SOC is 0% when the battery is in a minimum charged state.

The SOC of the battery may be estimated according to a change in an Open Circuit Voltage (OCV) of the battery. Here, the open circuit voltage of the battery may refer to an electromotive force applied to the battery in a state in which nothing is connected to the battery. At this time, the open circuit voltage of the battery may vary according to the SOC of the battery.

For example, the SOC of the battery when the AC impedance measurement unit (100) calculates the first resistance value may be within a range of 10% to 90%. Preferably, the AC impedance measurement unit (100) may be configured to calculate the first resistance value when the SOC of the battery is 50%. However, the present invention is not limited thereto, and the AC impedance measurement unit (100) may be configured to calculate the first resistance value based on an SOC of a specific value (%).

For example, the first resistance value may be calculated at an SOC of 50%, and in this case, in order to calculate the first resistance value, when the SOC is 100% upon receipt of the battery, the battery diagnostic apparatus (10) may discharge the battery such that the SOC becomes 50%, and when the SOC is 0% upon receipt of the battery, the battery diagnostic apparatus (10) may charge the battery such that the SOC becomes 50%.

In addition, the AC impedance value of the battery may include a second resistance value.

The second resistance value may refer to an internal resistance value of the battery when the SOP of the battery is 0%, calculated by the AC impedance measurement unit (100) based on a lowest voltage value (Vunder-limit) within an available voltage range of the battery.

Here, the lowest voltage value within the available voltage range of the battery refers to the lowest voltage value in a voltage region in which the battery is operable.

Meanwhile, the second resistance value may also be calculated by a Direct Current Internal Resistance (DCIR) measurement method or an Alternating Current Internal Resistance (ACIR) measurement method.

More specifically, the second resistance value may be expressed as Equation 2 below. ${R}_{lim} = \frac{{OCV}_{SOCx} - {V}_{under - limit}}{I}$

In Equation 2, Rₗᵢₘ is the second resistance value, OCV_{socx} is an open circuit voltage value of the battery when the SOC is within an arbitrary range, V_{under-limit} is the lowest voltage value within the available voltage range of the battery, and I denotes a current value when the battery is at the lowest voltage value.

That is, the second resistance value may be calculated by the AC impedance measurement unit (100) as a ratio of a current value when the battery is at the lowest voltage value to a difference between an open circuit voltage value of the battery when the SOC is within an arbitrary range at a temperature of 25°C and the lowest voltage value within the available voltage range of the battery.

For example, the SOC of the battery when the AC impedance measurement unit (100) calculates the second resistance value may be within a range of 10% to 90%. Further, preferably, the AC impedance measurement unit (100) may be configured to calculate the second resistance value when the SOC of the battery is 50%.

In addition, the AC impedance value of the battery may include a third resistance value.

The third resistance value may refer to a current internal resistance value of the battery calculated by the AC impedance measurement unit (100) based on a current discharge voltage value (V_{discharge-socx}) of the battery.

Meanwhile, the third resistance value may also be calculated by a Direct Current Internal Resistance (DCIR) measurement method or an Alternating Current Internal Resistance (ACIR) measurement method.

More specifically, the third resistance value may be expressed as Equation 3 below. ${R}_{m - adj} = \frac{{OCV}_{socx} - {V}_{discharge socx}}{I}$

In Equation 3, R_{m-adj} is the third resistance value, OCV_{socx} is an open circuit voltage value of the battery when the SOC is within an arbitrary range, V_{discharge-socx} is a current discharge voltage value of the battery, and I denotes a current value of the battery.

That is, the third resistance value may be calculated by the AC impedance measurement unit (100) as a ratio of a current value of the battery to a difference between an open circuit voltage (OCV) value of the battery when the SOC is within an arbitrary range at a temperature of 25°C and a current discharge voltage value of the battery.

For example, the SOC of the battery when the AC impedance measurement unit (100) calculates the third resistance value may be within a range of 10% to 90%. Further, preferably, the AC impedance measurement unit (100) may be configured to calculate the third resistance value when the SOC of the battery is 50%. Meanwhile, the AC impedance measurement unit (100) may calculate the third resistance value by determining an open circuit voltage (OCV) of the battery based on the SOC (%) of the battery set when calculating the first resistance value.

The SOP calculation unit (200) may be configured to calculate a current state of power (SOP) of the battery using the above-described first resistance value to third resistance value.

The current state of power (SOP) of the battery may be expressed as Equation 4 below. ${SOP}_{lim power - adj} = \left\{1-\frac{{R}_{m - adj} - {R}_{100}}{{R}_{lim} - {R}_{100}}\right\} ∗ 100 \left(%\right)$

In Equation 4, SO_{Plimit power-adj} denotes the current state of power (SOP) of the battery.

As can be seen from Equation 4, the current state of power of the battery may be calculated by the AC impedance measurement unit (100) based on a ratio of a "second value," which is a difference between the second resistance value and the first resistance value, to a "first value," which is a difference between the third resistance value and the first resistance value. That is, the current state of power of the battery may be calculated based on the first resistance value, which is an AC impedance value of the battery in an initial state when the SOP is 100%, and the second resistance value, which is an AC impedance value of the battery when the SOP is 0%.

According to this embodiment of the present invention, since the current state of power of the battery can be calculated by using an AC impedance value of the battery in an initial state when the SOP is 100% and an AC impedance value of the battery when the SOP is 0%, there is an advantage in that the SOP, which is a performance determination indicator of a starting battery, can be calculated more easily without a separate complicated calculation apparatus or calculation method.

For example, in the battery diagnostic apparatus (10) of the present invention, when the SOC of the battery is 50% and a current value when the battery is at the lowest voltage value is 100 A, the first resistance value may be calculated as 0.07 Ω. Further, the lowest voltage value within the available voltage range of the battery may be 300 V, and the OCV (when the SOC is 50%) may be 350 V. Accordingly, the second resistance value may be calculated as 0.5 Ω as shown in Equation below.${R}_{lim} = \frac{{OCV}_{SOCx} - {V}_{under - limit}}{I} = \frac{350 - 300}{100} = 0.5$

In addition, a current discharge voltage value of the battery may be 340 V, and a current value of the battery may be 100 A. Accordingly, the third resistance value may be calculated as 0.1 Q as shown in Equation below.${R}_{m - adj} = \frac{{OCV}_{socx} - {V}_{discharge socx}}{I} = \frac{350 - 340}{100} = 0.1$

Further, the current state of power of the battery may be calculated as 93%, as shown in Equation below, using the first resistance value to the third resistance value.$\begin{matrix}SO {P}_{limit power - adj} = \left(1-\frac{{R}_{m - adj} - {R}_{100}}{{R}_{lim} - {R}_{100}}\right) ∗ 100 \left(%\right) = \left(1-\frac{0.1 - 0.07}{0.5 - 0.07}\right) ∗ 100 \left(%\right) \\ = 93 \left(%\right)\end{matrix}$

Meanwhile, the battery diagnostic apparatus (10) may further include a temperature value correction unit (300), as illustrated in FIG. 1. At this time, the temperature value correction unit (300) may be provided within the above-described MCU. The temperature value correction unit (300) may be configured to correct the AC impedance value of the battery according to a temperature of the battery measured by a temperature measurement sensor.

The temperature value correction unit (300) may be configured to correct the first resistance value to the third resistance value according to a measured battery temperature, in consideration of a fact that, as the battery temperature decreases, a chemical reaction according to charging/discharging inside the battery becomes slower, thereby increasing an internal resistance value of the battery. As an example, the temperature value correction unit (300) may be configured to correct the first resistance value to the third resistance value according to the temperature of the battery measured by the temperature measurement sensor by using a preset internal resistance database (not shown) for each battery temperature.

In addition, the battery diagnostic apparatus (10) may further include a current value correction unit (400), as illustrated in FIG. 1. At this time, the current value correction unit (400) may be provided within the above-described MCU. The current value correction unit (400) may be configured to correct the AC impedance value of the battery according to a (charge/discharge) current of the battery measured by a current measurement sensor.

The current value correction unit (400) may be a configuration for allowing measurement of the AC impedance of the battery to be performed in consideration of characteristics of the battery according to a C-rate. As an example, the current value correction unit (400) may be configured to correct the first resistance value to the third resistance value according to a current of the battery measured by the current measurement sensor by using a preset internal resistance database (not shown) for each battery current.

FIG. 2 is a flowchart illustrating a battery diagnostic method according to an embodiment of the present invention.

Referring to FIG. 2, the battery diagnostic method according to an embodiment of the present invention includes steps S1 and S2 below.

In step S1, an AC impedance value of the battery is measured based on a lowest voltage value within an available voltage range of the battery and a current discharge voltage value of the battery. At this time, step S1 may be performed by the above-described AC impedance measurement unit (100).

In step S2, a current state of power of the battery is calculated based on the measured AC impedance value. At this time, step S2 may be performed by the above-described SOP calculation unit (200).

As described above, although the present invention has been described with reference to limited embodiments and drawings, the present invention is not limited thereto, and it will be apparent that various modifications and variations may be made by those skilled in the art to which the present invention pertains within the technical spirit of the present invention and the equivalent scope of the claims to be set forth below.

Meanwhile, although terms indicating directions such as upper, lower, left, right, front, and rear are used in the present invention, it will be apparent to those skilled in the art that such terms are merely for convenience of description and may vary depending on the position of an object to be referred to, the position of an observer, and the like.

### [Description of Reference Numerals]

10: Battery Diagnostic Apparatus
100: AC Impedance Measurement Unit
200: SOP Calculation Unit
300: Temperature Value Correction Unit
400: Current Value Correction Unit

## Claims

1. A battery diagnostic apparatus comprising:
an AC impedance measurement unit configured to measure an AC impedance value of a battery based on a lowest voltage value within an available voltage range of the battery and a current discharge voltage value of the battery; and
an SOP calculation unit configured to calculate a current state of power (SOP) of the battery based on the measured AC impedance value.

2. The battery diagnostic apparatus according to claim 1,
wherein the AC impedance value of the battery comprises a first resistance value calculated by the AC impedance measurement unit when the battery is in an initial state and a state of charge (SOC) is in a range of 10% to 90% at a temperature of 25°C.

3. The battery diagnostic apparatus according to claim 2,
wherein the AC impedance measurement unit is configured to calculate the first resistance value when the SOC of the battery is 50%.

4. The battery diagnostic apparatus according to claim 2,
wherein the AC impedance value of the battery further comprises a second resistance value calculated by the AC impedance measurement unit based on a lowest voltage value within an available voltage range of the battery.

5. The battery diagnostic apparatus according to claim 4,
wherein the second resistance value is calculated as a ratio of a current value when the battery is at the lowest voltage value to a difference between an open circuit voltage (OCV) value of the battery when the SOC is in a range of 10% to 90% at a temperature of 25°C and the lowest voltage value within the available voltage range of the battery.

6. The battery diagnostic apparatus according to claim 5,
wherein the AC impedance measurement unit is configured to calculate the second resistance value when the SOC of the battery is 50%.

7. The battery diagnostic apparatus according to claim 4,
wherein the AC impedance value of the battery further comprises a third resistance value calculated by the AC impedance measurement unit based on a current discharge voltage value of the battery.

8. The battery diagnostic apparatus according to claim 7,
wherein the third resistance value is calculated as a ratio of a current value of the battery to a difference between an open circuit voltage (OCV) value of the battery when the SOC is in a range of 10% to 90% at a temperature of 25°C and a current discharge voltage value of the battery.

9. The battery diagnostic apparatus according to claim 8,
wherein the AC impedance measurement unit is configured to calculate the third resistance value when the SOC of the battery is 50%.

10. The battery diagnostic apparatus according to claim 7,
wherein the SOP calculation unit is configured to calculate the current state of power of the battery based on a ratio of a second value, which is a difference between the second resistance value and the first resistance value, to a first value, which is a difference between the third resistance value and the first resistance value.

11. A battery diagnostic method comprising:
measuring an AC impedance value of a battery based on a lowest voltage value within an available voltage range of the battery and a current discharge voltage value of the battery; and
calculating a current state of power of the battery based on the measured AC impedance value.
